# EUROPEAN PATENT APPLICATION

(11) **EP 4 848 339 A1**
(43) Date of publication of application: **02.12.2026**
(21) Application number: 24920068.4
(22) Date of filing: 23.12.2024
(51) Int. Cl.: H01L 23/29, H01L 23/31, H01L 21/60, H01L 23/12, H01L 25/07, H01L 25/18, H01L 25/065

(54) **SEMICONDUCTOR APPARATUS AND METHOD FOR MANUFACTURING SEMICONDUCTOR APPARATUS**

(30) Priority: 25.01.2024 JP 2024009773; 27.03.2024 JP 2024051986
(71) Applicant: Rapidus Corporation, Tokyo 102-0083 (JP)
(72) Inventor: OOIDA, Mitsuru, Tokyo 102-0083 (JP)
(74) Representative: MFG Patentanwälte Meyer-Wildhagen Meggle-Freund Gerhard PartG mbB
(86) International application number: PCT/JP2024/045433
(87) International publication number: WO 2025/158845

(57) **Abstract**

To provide a semiconductor device 1 that enables highly reliable fine-pitch flip-chip connection.

In a semiconductor device 1, semiconductor dies 10 and 30 include silicon substrates 11 and 31 and electrodes 12 and 32 formed on the silicon substrates 11 and 31, organic insulating films 14 and 34 are formed on the semiconductor dies 10 and 30, openings 64 and 74 that expose the electrodes 12 and 32 are formed in the organic insulating films 14 and 34, outer peripheries 63 and 73 of the organic insulating films 14 and 34 are located inside outer peripheries 60 and 70 of the semiconductor dies 10 and 30, and the outer peripheries 63 and 73 of the organic insulating films 14 and 34 are covered with mold resin.

## Description

### Technical Field

The present invention relates to a semiconductor device, particularly to a semiconductor device capable of fine-pitch interconnection, and to a method for manufacturing the semiconductor device.

### Background Art

Conventionally, in general flip-chip connection, underfill is filled after a bump formed on a chip is connected to an opposing electrode. As a connection pitch becomes finer, a gap between a chip and a substrate becomes narrower, and fillability becomes poorer. Therefore, a technique has been proposed in which a bump is covered with resin after formation of the bump and the bump is exposed by grinding. Patent Literature 1 exists as a document disclosing a bonding method for a flip-chip-type semiconductor element related to this technique. Patent Literature 1 discloses a technique in which flip-chip connection is performed after an embedded-film resist is formed on one substrate.

### Citation List

### Patent Literature

Patent Literature 1: JP H07-249732 A.

### Summary of Invention

### Technical Problem

The above-described conventional flip-chip connection in which underfill is filled has a problem in that, as the connection pitch becomes finer, portions into which the underfill is not filled are generated, and connection reliability degrades.

Accordingly, flip-chip connection has been proposed in which a bump is covered with resin after formation of the bump and the bump is exposed at the time of connection. This flip-chip connection has a problem in that connection is not stable and connection reliability cannot be ensured.

In a semiconductor device having low connection reliability, cracks are easily generated or connection portions fracture when force such as warpage is applied.

Accordingly, an object of the present invention is to provide a semiconductor device that enables highly reliable fine-pitch flip-chip connection.

### Solution to Problem

A semiconductor device of the present invention is a semiconductor device including a semiconductor die flip-chip connected to a semiconductor die to be connected or a substrate, in which the semiconductor die includes a silicon substrate and an electrode formed on the silicon substrate, an organic insulating film is formed on the semiconductor die, an opening that exposes the electrode is formed in the organic insulating film, an outer periphery of the organic insulating film is located inside an outer periphery of the semiconductor die, and the outer periphery of the organic insulating film is covered with mold resin.

In addition, a method for manufacturing a semiconductor device of the present invention includes: a step of forming an organic insulating film on one principal surface of a semiconductor die on which an electrode is formed; a step of opening the organic insulating film on the electrode; a step of curing the organic insulating film; a step of filling metal into the opened portion; a step of removing the organic insulating film in an outer peripheral portion of the semiconductor die; a step of cutting the semiconductor die in a portion from which the organic insulating film has been removed; a step of aligning the cut semiconductor die and a semiconductor die to be connected or a substrate and simultaneously performing bonding of the organic insulating film and connection of the metal; and a step of sealing the outer peripheral portion with mold resin.

### Advantageous Effects of Invention

According to the present invention, a semiconductor device that enables highly reliable fine-pitch flip-chip connection can be provided.

### Brief Description of Drawings

Fig. 1 is a cross-sectional view of a semiconductor device according to an embodiment of the present invention.
Fig. 2 is a cross-sectional view of a semiconductor die before flip-chip connection in a semiconductor device according to the embodiment of the present invention.
Fig. 3 is a view showing behavior of warpage of a package substrate due to temperature.
Fig. 4 is a cross-sectional view of a semiconductor device and a package substrate according to the embodiment of the present invention.
Fig. 5 is a cross-sectional view of a conventional semiconductor device and a package substrate.
Fig. 6 is a view showing physical properties of an underfill material and mold resin.
Fig. 7A is a cross-sectional view for explaining a method for manufacturing a semiconductor device according to the embodiment of the present invention.
Fig. 7B is a cross-sectional view for explaining a method for manufacturing a semiconductor device according to the embodiment of the present invention.
Fig. 7C is a cross-sectional view for explaining a method for manufacturing a semiconductor device according to the embodiment of the present invention.
Fig. 7D is a cross-sectional view for explaining a method for manufacturing a semiconductor device according to the embodiment of the present invention.
Fig. 7E is a cross-sectional view for explaining a method for manufacturing a semiconductor device according to the embodiment of the present invention.
Fig. 7F is a cross-sectional view for explaining a method for manufacturing a semiconductor device according to the embodiment of the present invention.
Fig. 7G is a cross-sectional view for explaining a method for manufacturing a semiconductor device according to the embodiment of the present invention.
Fig. 7H is a cross-sectional view for explaining a method for manufacturing a semiconductor device according to the embodiment of the present invention.
Fig. 7I is a cross-sectional view for explaining a method for manufacturing a semiconductor device according to the embodiment of the present invention.
Fig. 8 is a cross-sectional view of a semiconductor device according to a second embodiment of the present invention.
Fig. 9A is a cross-sectional view of a carrier substrate and the like for explaining a method for manufacturing a carrier wiring substrate according to the second embodiment of the present invention.
Fig. 9B is a cross-sectional view of a carrier substrate and the like for explaining a method for manufacturing a carrier wiring substrate according to the second embodiment of the present invention.
Fig. 9C is a cross-sectional view of a carrier substrate and the like for explaining a method for manufacturing a carrier wiring substrate according to the second embodiment of the present invention.
Fig. 9D is a cross-sectional view of a carrier substrate and the like for explaining a method for manufacturing a carrier wiring substrate according to the second embodiment of the present invention.
Fig. 10A is a cross-sectional view for explaining a method for manufacturing a chip according to the second embodiment of the present invention.
Fig. 10B is a cross-sectional view for explaining a method for manufacturing a chip according to the second embodiment of the present invention.
Fig. 10C is a cross-sectional view for explaining a method for manufacturing a chip according to the second embodiment of the present invention.
Fig. 10D is a cross-sectional view for explaining a method for manufacturing a chip according to the second embodiment of the present invention.
Fig. 11 is a cross-sectional view for explaining a method for manufacturing a semiconductor device according to the second embodiment of the present invention.
Fig. 12 is an overall view showing a semiconductor device according to the second embodiment of the present invention.
Fig. 13 is an overall view showing a conventional semiconductor device.
Fig. 14 is an overall view showing another example of a semiconductor device according to the second embodiment of the present invention.
Fig. 15 is an overall view showing another example of the conventional semiconductor device.

### Description of Embodiments

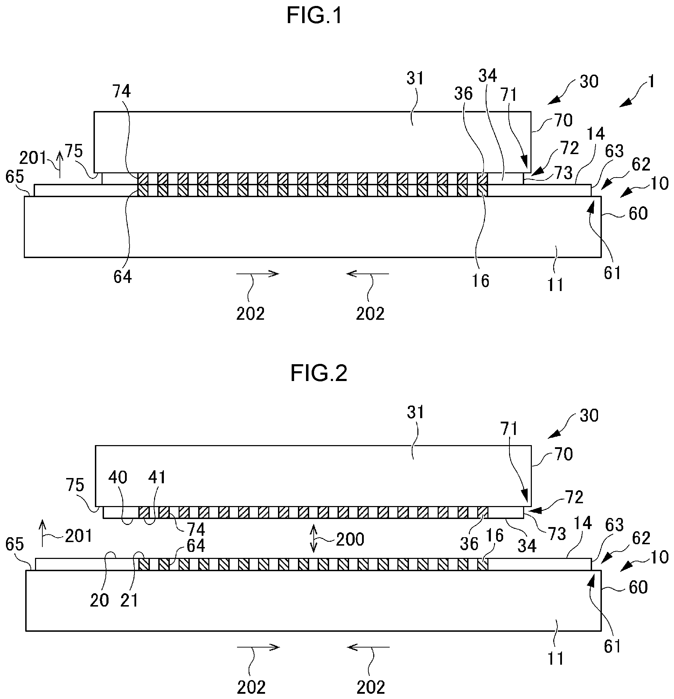

Embodiments for carrying out the invention will be described with reference to the drawings. Fig. 1 is a cross-sectional view of a semiconductor device 1 according to an embodiment of the present invention. Fig. 2 is a cross-sectional view of a first semiconductor die 10 and a second semiconductor die 30 before flip-chip connection in the semiconductor device 1.

Note that the semiconductor device 1 is one in which a semiconductor die is mounted on another wiring substrate. Examples of the other wiring substrate include a semiconductor die including active elements such as semiconductor elements, a wiring-only substrate that does not include active elements, such as a silicon interposer, and a substrate in which a wiring layer is formed on a glass carrier. Hereinafter, the semiconductor device 1 will be described by taking, as an example, a case in which the other wiring substrate is a semiconductor die (the first semiconductor die 10). The semiconductor die as the other wiring substrate can also be referred to as a semiconductor die to be connected. Here, the semiconductor die to be connected means another semiconductor die connected to one semiconductor die.

### (Overview of Semiconductor Device)

As shown in Fig. 1, a semiconductor device 1 is one in which a first semiconductor die 10 and a second semiconductor die 30 are flip-chip connected. The semiconductor device 1 is formed by connecting the first semiconductor die 10 and the second semiconductor die 30 in a direction of an arrow 200 shown in Fig. 2. The direction of the arrow 200 is referred to as the connection direction 200. In addition, the first semiconductor die 10 and the second semiconductor die 30 may be referred to as two semiconductor dies, or as the respective semiconductor dies.

### (Semiconductor Die)

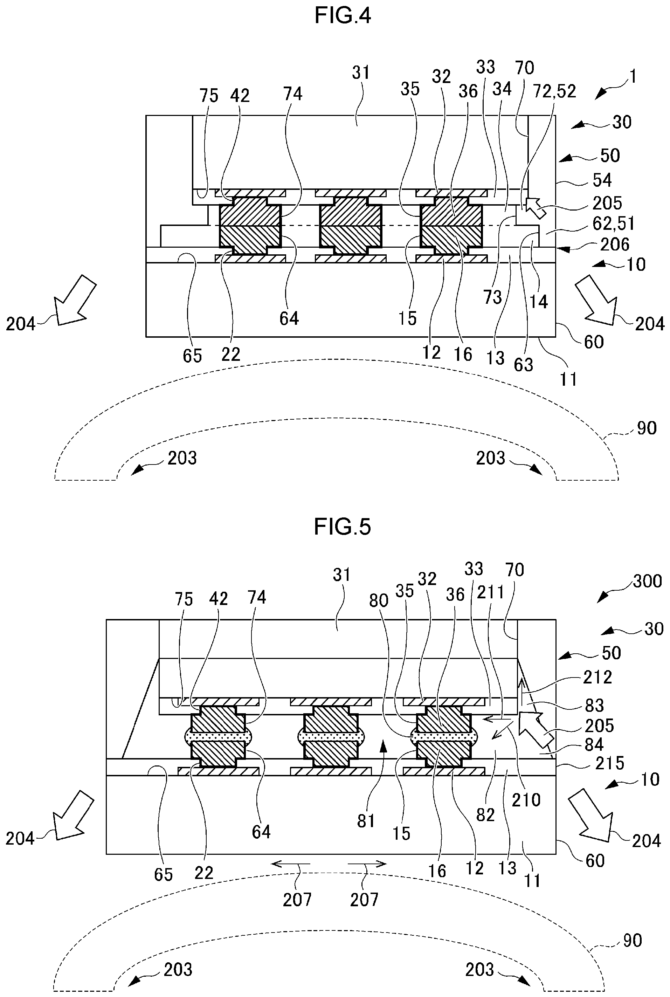

A semiconductor die will be described by taking the first semiconductor die 10 as an example. The second semiconductor die 30 also has a configuration similar to that of the first semiconductor die 10. The first semiconductor die 10 mainly includes a first silicon substrate 11 and a first electrode 12. The first electrode 12 is not shown in Figs. 1 and 2. The first electrode 12 is shown in Fig. 4 and the like.

### (Organic Insulating Film)

A first organic insulating film 14 and a first bump 16 are formed on one principal surface 65 of the first silicon substrate 11. With respect to the principal surface 65 of the first silicon substrate 11, a direction perpendicular to the principal surface 65 and away from the principal surface 65 is referred to as an upward direction. In Fig. 1, the direction indicated by an arrow 201 is an upward direction 201. The upward direction 201 is similarly defined also for a second silicon substrate 31. An opening 64 is formed in the first organic insulating film 14. The opening 64 is formed on the first electrode 12. The opening 64 exposes the first electrode 12 from the first organic insulating film 14.

### (Bump)

The first bump 16 is formed within the opening 64. The first bump 16 is electrically connected to the first electrode 12.

Referring to Fig. 2, in the first semiconductor die 10 of the present embodiment, a surface 20 of the first organic insulating film 14 and a surface 21 of the first bump 16 are flush with each other.

The structure of the second semiconductor die 30 is similar to the structure of the first semiconductor die 10. As shown in Figs. 1 and 2, in the second semiconductor die 30, the second silicon substrate 31 corresponds to the first silicon substrate 11. A second electrode 32 corresponds to the first electrode 12. The second electrode 32 is not shown in Figs. 1 and 2. The second electrode 32 is shown in Fig. 4 and the like.

Also in the second semiconductor die 30, an organic insulating film and a bump are formed similarly to the first semiconductor die 10. A second organic insulating film 34 corresponds to the first organic insulating film 14. An opening 74 of the second organic insulating film 34 corresponds to the opening 64 of the first organic insulating film 14. A second bump 36 corresponds to the first bump 16. The second bump 36 is electrically connected to the second electrode 32.

Referring to Fig. 2, in the second semiconductor die 30 of the present embodiment, similarly to the first semiconductor die 10, a surface 40 of the second organic insulating film 34 and a surface 41 of the second bump 36 are flush with each other.

### (Flip-Chip Connection)

The first semiconductor die 10 and the second semiconductor die 30 are flip-chip connected in the connection direction 200 in a state in which the position of the first bump 16 of the first semiconductor die 10 and the position of the second bump 36 of the second semiconductor die 30 are aligned.

### (Missing Portion of Organic Insulating Film)

In the semiconductor device 1 of the present embodiment, a missing portion of the organic insulating film is formed in an outer peripheral portion of a semiconductor die. The missing portion of the organic insulating film means a portion in which the organic insulating film is not formed. As shown in Figs. 1 and 2, in the first semiconductor die 10, a missing portion 62 of the first organic insulating film 14, where the first organic insulating film 14 is absent, is formed in an outer peripheral portion 61 of the first semiconductor die 10. Here, the outer peripheral portion 61 refers to an outer peripheral region on the principal surface 65 side of the first silicon substrate 11. Because the missing portion 62 is formed, an outer periphery 63 of the first organic insulating film 14 is located inside an outer periphery 60 of the first semiconductor die 10. The term "inside" refers to the direction indicated by arrow 202 in Figs. 1 and 2. The direction indicated by the arrow 202 is referred to as the inward direction.

Also in the second semiconductor die 30, a missing portion of the organic insulating film is formed similarly to the first semiconductor die 10. In the second semiconductor die 30, an outer periphery 70 of the second semiconductor die 30 corresponds to the outer periphery 60 of the first semiconductor die 10. An outer peripheral portion 71 of the second semiconductor die 30 corresponds to the outer peripheral portion 61 of the first semiconductor die 10. A missing portion 72 of the second organic insulating film 34 corresponds to the missing portion 62 of the first organic insulating film 14. An outer periphery 73 of the second organic insulating film 34 corresponds to the outer periphery 63 of the first organic insulating film 14.

The material of the organic insulating film is not particularly limited. An example of the material of the organic insulating film is photosensitive polyimide. The material of the bump is not particularly limited. Examples of the material of the bump are solder and copper. The material of the first bump 16 and the material of the second bump 36 can also be made different from each other. For example, the material of the first bump 16 can be copper, and the material of the second bump 36 can be solder.

In the above description, a configuration has been described in which the outer periphery 70 of the second semiconductor die 30 is located on the inward direction 202 side of the outer periphery 60 of the first semiconductor die 10. The size, arrangement, and the like of the first semiconductor die 10 and the second semiconductor die 30 are not limited to the example in the above description.

### (Mounting on Package Substrate)

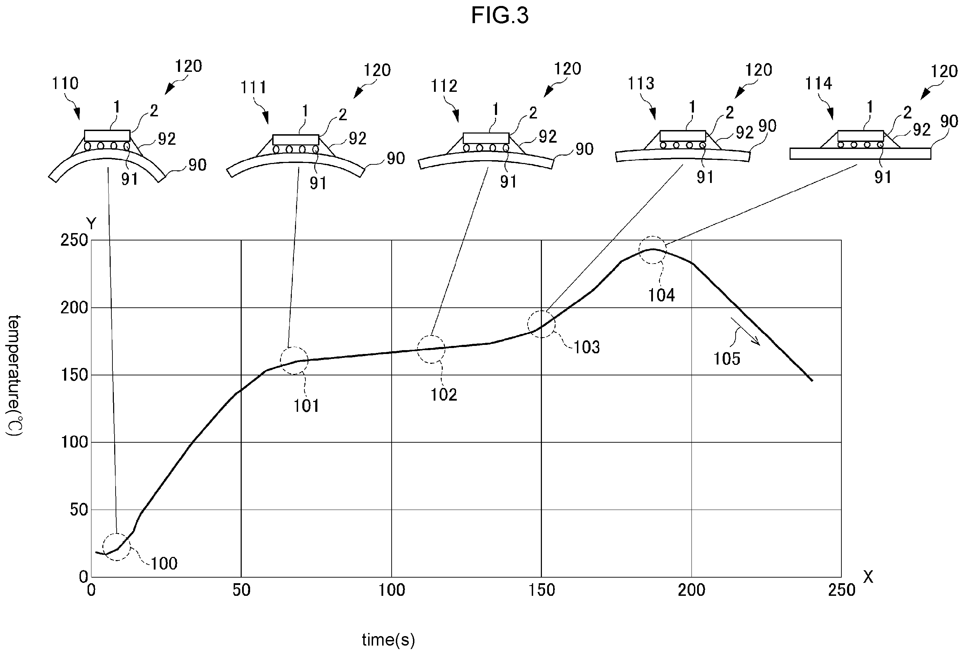

A case in which the semiconductor device 1 is used after being mounted on a package substrate 90 will be described. Fig. 3 is a view showing behavior of warpage of the package substrate 90 due to temperature. A horizontal axis X of the graph shown in Fig. 3 is time (seconds). A vertical axis Y is temperature (°C).

A structure in which the semiconductor device 1 is mounted on the package substrate 90 is referred to as a package 120. As shown in Fig. 3, the semiconductor device 1 is mounted on the package substrate 90 through a package bump 91. A package sealing material 92 is disposed in a region between the semiconductor device 1 and the package substrate 90 and on at least a part of an outer periphery 2 of the semiconductor device 1. The outer periphery 2 of the semiconductor device 1 means an outermost portion among members constituting the semiconductor device 1, such as the first semiconductor die 10, the second semiconductor die 30, and a mold resin portion 50.

For example, in a reflow step and the like, when heat is applied to the package substrate 90, behavior of warpage of the package substrate 90 changes. The views indicated by arrows 110 to 114 in Fig. 3 respectively show states of a package 120 in frames 100 to 104 of the graph. The package substrate 90 is further cooled from the frame 104 (see arrow 105), and when the package substrate 90 is cooled to room temperature, for example, 25°C, the package substrate 90 returns to a warped state as indicated by the arrow 110.

When the package substrate 90 shows the behavior of warpage as shown in Fig. 3, force is applied to the semiconductor device 1. The force causes defects in the semiconductor device 1.

With reference to Fig. 4, when the semiconductor device 1 is mounted on the package substrate 90 in a step involving heating such as reflow, the force applied to the semiconductor device 1 due to warpage will be described. Fig. 4 is a cross-sectional view of the semiconductor device 1 and the package substrate 90.

### (Configuration of Semiconductor Device)

Before the force due to warpage is described, a configuration of the semiconductor device 1 that is not shown in Figs. 1 and 2 will be described. As shown in Fig. 4, the first electrode 12 is formed on the principal surface 65 of the first silicon substrate 11. Similarly, the second electrode 32 is formed on a principal surface 75 of the second silicon substrate 31.

A first oxide film 13 is formed on the principal surface 65 of the first silicon substrate 11. Similarly, a second oxide film 33 is formed on the principal surface 75 of the second silicon substrate 31. An opening 22 is formed in the first oxide film 13. The opening 22 is formed on the first electrode 12. The opening 64 exposes the first electrode 12 from the first oxide film 13. Similarly, an opening 42 is formed in the second oxide film 33. The opening 42 is formed on the second electrode 32. The opening 42 exposes the second electrode 32 from the second oxide film 33.

A first metal film 15 is formed on the surface of the first electrode 12 exposed by the opening 22 of the first oxide film 13, on an inner surface of the opening 22, and on an inner surface of the opening 64 of the first organic insulating film 14. Similarly, a second metal film 35 is formed on the surface of the second electrode 32 exposed by the opening 42 of the second oxide film 33, on an inner surface of the opening 42, and on an inner surface of the opening 74 of the second organic insulating film 34.

The first metal film 15 and the second metal film 35 function, for example, as plating seed layers. Plating is used when metal for bumps is filled into the respective openings and the like.

In addition, as described above with reference to Figs. 1 and 2, the first bump 16 is formed inside the opening 64 of the first organic insulating film 14. Similarly, the second bump 36 is formed inside the opening 74 of the second organic insulating film 34. In addition, the first organic insulating film 14 is formed, for example, between the first bumps 16. Similarly, the second organic insulating film 34 is formed between the second bumps 36.

### (Mold Resin Portion)

The semiconductor device 1 after flip-chip connection is molded with mold resin. A portion in which mold resin is disposed is referred to as a mold resin portion 50. In the example shown in Fig. 4, the mold resin portion 50 covers the outer periphery 70 of the second semiconductor die 30, the outer periphery 73 of the second organic insulating film 34, and the outer periphery 63 of the first organic insulating film 14. In addition, the mold resin portion 50 covers the outer periphery 70 of the second semiconductor die 30. In addition, an outer periphery 54 of the mold resin portion 50 and the outer periphery 60 of the first semiconductor die 10 are flush with each other.

### (Force Due to Warpage)

The force due to warpage will be described. As shown in Fig. 3, a state of warpage of the package substrate 90 changes depending on a temperature of the package substrate 90. For example, when the package substrate 90 is cooled from a high temperature of 200°C or higher to room temperature, the package substrate 90 warps in a direction of an arrow 203 shown in Fig. 4. As a result, force that warps the semiconductor device 1 in a direction of an arrow 204 is applied to the semiconductor device 1. An arrow 205 in Fig. 4 indicates a corner portion 205 of the second semiconductor die 30 on the first semiconductor die 10 side. The force that warps the semiconductor device 1 in the direction of the arrow 204 is likely to be applied to the corner portion 205 of the second semiconductor die 30 on the first semiconductor die 10 side.

In the semiconductor device 1 of the present embodiment, the missing portion 72 is formed in the second organic insulating film 34. Mold resin is filled in the missing portion 72. In the mold resin portion 50, a portion in which mold resin is filled in the missing portion 72 is referred to as a second insulating film side surface filling portion 52 of the mold resin portion 50. Because the second insulating film side surface filling portion 52 is formed, the corner portion 205 of the second semiconductor die 30 is covered with mold resin. As a result, a defect is less likely to spread from the corner portion 205 of the second semiconductor die 30 as a starting point. Therefore, highly reliable flip-chip connection can be realized. Accordingly, in the present invention, formation of the missing portion 72 in the second organic insulating film 34 is particularly important.

In addition, in the semiconductor device 1 of the present embodiment, the missing portion 62 is formed in the first organic insulating film 14. Mold resin is filled in the missing portion 62. In the mold resin portion 50, a portion in which mold resin is filled in the missing portion 62 is referred to as a first insulating film side surface filling portion 51 of the mold resin portion 50. Because the first insulating film side surface filling portion 51 is formed, sufficient mold resin is disposed at a corner portion 206 of the first semiconductor die 10 on the second semiconductor die 30 side. As a result, a defect is less likely to spread from the corner portion 206 of the first semiconductor die 10 as a starting point. Therefore, highly reliable flip-chip connection can be realized.

### (Mold Resin and Organic Insulating Film)

Distribution of force applied to the corner portion 205 due to warpage of the package substrate 90 and the like will be described in relation to the presence or absence of the missing portion of the organic insulating film. As shown in Fig. 4, the missing portion 72 of the second organic insulating film 34 is formed in the semiconductor device 1 of the present embodiment. The second insulating film side surface filling portion 52 is formed in the missing portion 72. In addition, the outer periphery 70 of the second semiconductor die 30 is covered with the mold resin portion 50. Therefore, the corner portion 205 is covered with the mold resin portion 50. On the other hand, when the missing portion 72 of the second organic insulating film 34 is not formed, the second organic insulating film 34 is disposed at the corner portion 205.

### (Flexural Modulus)

A material forming the mold resin portion 50 has a higher flexural modulus than a material forming the organic insulating film. Therefore, in the semiconductor device 1 of the present embodiment, force applied to the corner portion 205 is more readily distributed than in a case where the missing portion 72 of the second organic insulating film 34 is not formed and the second organic insulating film 34 is disposed at the corner portion 205.

### (Coefficient of Thermal Expansion)

In addition, a material forming the mold resin portion 50 has a smaller coefficient of thermal expansion than a material forming the organic insulating film. Therefore, in the semiconductor device 1 of the present embodiment, thermal stress is less likely to be applied to the corner portion 205 than in a case where the missing portion 72 of the second organic insulating film 34 is not formed and the second organic insulating film 34 is disposed at the corner portion 205.

For the reasons described above, a connection failure such as a crack in a bump is less likely to occur in the semiconductor device 1 of the present embodiment. The semiconductor device 1 of the present embodiment can provide highly reliable flip-chip connection.

### (Mold Resin and Underfill)

Distribution of force applied to the corner portion 205 due to warpage of the package substrate 90 and the like will be described in comparison with a conventional semiconductor device 300 in which an underfill 81 is disposed. First, with reference to Fig. 5, a configuration of the conventional semiconductor device 300 will be described. Fig. 5 is a cross-sectional view of the conventional semiconductor device and a package substrate. The conventional semiconductor device 300 will be described focusing mainly on matters different from the semiconductor device 1 of the present embodiment shown in Fig. 4.

### (Underfill)

In the semiconductor device 1 of the present embodiment, an organic insulating film is disposed in portions other than bumps in a region between the first semiconductor die 10 and the second semiconductor die 30. In contrast, in the conventional semiconductor device 300, the underfill 81 is disposed in portions other than bumps in a region between the first semiconductor die 10 and the second semiconductor die 30 and the like.

In the semiconductor device 300 shown in Fig. 5, the first bump 16 and the second bump 36 are connected through solder 80. The underfill 81 is disposed so as to fill portions where the first bump 16, the second bump 36, and the solder 80 are not present in a region sandwiched between the first semiconductor die 10 and the second semiconductor die 30.

The underfill 81 includes a device-opposing portion 82, a wetting rise portion 83, and a wetting spread portion 84. The device-opposing portion 82 is a portion of the underfill 81 located between the first semiconductor die 10 and the second semiconductor die 30. The wetting rise portion 83 is a portion of the underfill 81 that covers the outer periphery 70 of the second semiconductor die 30. The wetting rise portion 83 is also referred to as a fillet. The wetting spread portion 84 is a portion of the underfill 81 that covers the first semiconductor die 10 in a portion that does not face the second semiconductor die 30.

As described above, the underfill 81 includes the device-opposing portion 82, the wetting rise portion 83, and the wetting spread portion 84. Therefore, in the conventional semiconductor device 300, the corner portion 205 of the second semiconductor die 30 is covered with the underfill 81.

A case where force is applied to the corner portion 205 of the semiconductor device 1 of the present embodiment and a case where force is applied to the corner portion 205 of the conventional semiconductor device 300 shown in Fig. 5 will be comparatively described from a viewpoint of material physical properties.

### (Physical Properties of Materials)

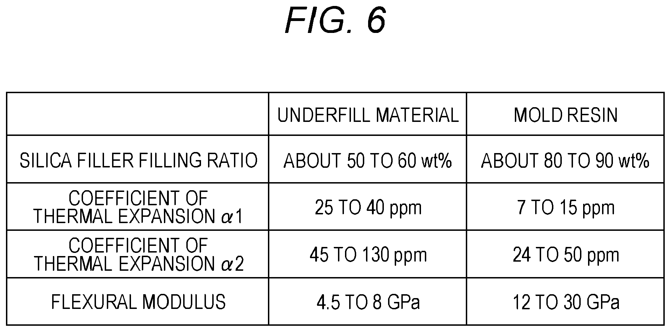

Fig. 6 is a view showing physical properties of an underfill material forming the underfill 81 and mold resin forming the mold resin portion 50. In Fig. 6, physical properties of epoxy resin are described as an example of the underfill material and an example of the mold resin.

As shown in Fig. 4, the corner portion 205 of the semiconductor device 1 of the present embodiment is covered with the mold resin portion 50. As shown in Fig. 5, the corner portion 205 of the conventional semiconductor device 300 is covered with the underfill 81.

### (Flexural Modulus)

As shown in Fig. 6, a flexural modulus of the mold resin is higher than a modulus of elasticity of the underfill material. Therefore, force applied to the corner portion 205 of the semiconductor device 1 of the present embodiment is more readily distributed in the mold resin portion 50. As a result, connection failure is less likely to occur. In contrast, a modulus of elasticity of the underfill material is lower than the flexural modulus of the mold resin. Therefore, fracture is likely to occur in the underfill 81 due to force applied to the corner portion 205 of the conventional semiconductor device 300.

With reference to Fig. 5, propagation of force applied to the corner portion 205 in the conventional semiconductor device 300 will be described. When force due to warpage of the package substrate 90 is applied to the corner portion 205, the force propagates in directions of arrows 210 to 212. The direction of the arrow 210 is a direction from the corner portion 205 toward a midpoint in a distance direction between the first semiconductor die 10 and the second semiconductor die 30. The direction of the arrow 211 is a direction extending from the corner portion 205 along a surface of the second semiconductor die 30. The direction of the arrow 212 is a direction extending from the corner portion 205 along the outer periphery 70 of the second semiconductor die 30.

In the conventional semiconductor device 300, a modulus of elasticity of the underfill material is low. Therefore, stress directed in an outward direction 207 and generated by warping the semiconductor device 300 in the direction of an arrow 203 is less likely to be relieved. As a result, fracture of the underfill 81 is likely to occur in the directions shown by the arrows 210 to 212. In addition, stress applied in the vicinity of an end portion 215 of the first oxide film 13 becomes large, and a crack may occur in the vicinity of the outer periphery 60 of the first semiconductor die. As described above, reliability of the conventional semiconductor device 300 is low.

### (Coefficient of Thermal Expansion)

In addition, as shown in Fig. 6, a coefficient of thermal expansion of the mold resin is smaller than a coefficient of thermal expansion of the underfill material. Therefore, in the semiconductor device 1 of the present embodiment in which the corner portion 205 is covered with the mold resin portion 50, thermal stress is less likely to be applied to the corner portion 205 than in the conventional semiconductor device 300 in which the corner portion 205 is covered with the underfill 81. In particular, with regard to coefficients of thermal expansion, both coefficient of thermal expansion α1 (coefficient of thermal expansion in a temperature range lower than a glass transition temperature) and coefficient of thermal expansion α2 (coefficient of thermal expansion in a temperature range higher than the glass transition temperature) in a temperature range where expansion or contraction of resin is large are smaller for the mold resin than for the underfill material. Therefore, thermal stress is less likely to be applied to the corner portion 205 with the mold resin than with the underfill material.

In addition, a difference between a coefficient of thermal expansion of the mold resin and a coefficient of thermal expansion of the silicon substrate is smaller than a difference between a coefficient of thermal expansion of the underfill material and a coefficient of thermal expansion of the silicon substrate. Therefore, a crack due to a difference in coefficient of thermal expansion between resin and silicon is less likely to occur.

As described above, a high flexural modulus of the mold resin and a small coefficient of thermal expansion of the mold resin suppress spreading of defects in the mold resin portion 50. As a result, connection failure such as a crack in a bump is less likely to occur in the semiconductor device 1 of the present embodiment. The semiconductor device 1 of the present embodiment can provide highly reliable flip-chip connection.

### (Flatness)

In addition, as described with reference to Fig. 2, in the first semiconductor die 10 of the present embodiment, the surface 20 of the first organic insulating film 14 and the surface 21 of the first bump 16 are flush with each other. Similarly, in the second semiconductor die 30, the surface 40 of the second organic insulating film 34 and the surface 41 of the second bump 36 are flush with each other. Therefore, adhesion between the first semiconductor die 10 and the second semiconductor die 30 is improved. As a result, the semiconductor device 1 of the present embodiment can provide a semiconductor device that enables highly reliable fine-pitch flip-chip connection.

Note that the term "flush" does not mean only that the surface 20 of the first organic insulating film 14 and the surface 21 of the first bump 16 are in a same plane, or that the surface 40 of the second organic insulating film 34 and the surface 41 of the second bump 36 are in a same plane. For example, even when there is some step between a surface of the organic insulating film and a surface of the bump, the surface of the organic insulating film and the surface of the bump can be said to be flush with each other as long as the step is at a level that does not cause a mounting failure in a later mounting step.

When mounting is performed by flip-chip bonding, the organic insulating film is deformed by heat and load applied during bonding. Therefore, even when there is some step between the surface of the organic insulating film and the surface of the bump, the step is absorbed during flip-chip bonding, and connection at the bump surface is possible. Therefore, the expression that the surface of the organic insulating film and the surface of the bump are flush with each other means that there is no step exceeding a step that can be absorbed during flip-chip bonding. In other words, a recess level that is absorbable in flip-chip bonding can be regarded as being flush.

An example of a recess level that is absorbable in flip-chip bonding is a recessed shape in which, after chemical mechanical polishing (CMP), the surface of the bump is recessed below the surface of the organic insulating film. The shape is also referred to as Dish. A step height of the Dish may be about 10 nm or more and 150 nm or less depending on a metal type of the bump, conditions, and the like. Even when such a Dish is present, the surface of the organic insulating film and the surface of the bump can be said to be flush with each other.

### (Method for Manufacturing Semiconductor Device)

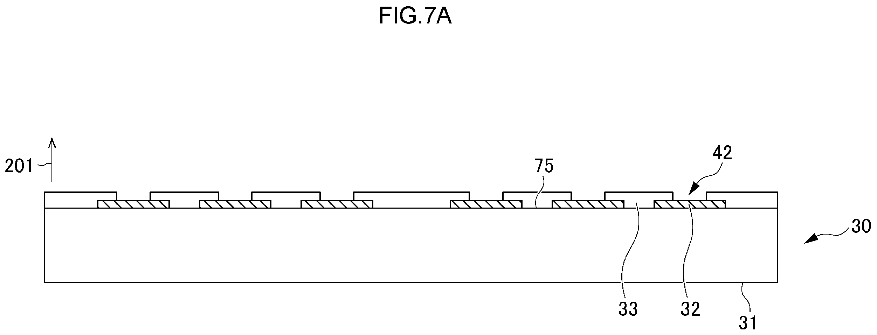

With reference to Figs. 7A to 7I, a method for manufacturing the semiconductor device 1 of the present embodiment will be described. Figs. 7A to 7I are cross-sectional views of a silicon substrate and the like. Figs. 7A to 7I show manufacturing steps of the semiconductor device 1 in order from Fig. 7A.

Hereinafter, the method for manufacturing the semiconductor device 1 will be described by taking the second semiconductor die 30 as an example. A method for manufacturing the first semiconductor die 10 is also similar to the method for manufacturing the second semiconductor die 30. In Figs. 7A to 7I, a portion that becomes the first semiconductor die 10 is indicated by a reference sign 10 even when the portion is unfinished. Similarly, a portion that becomes the second semiconductor die 30 is indicated by a reference sign 30 even when the portion is unfinished. The arrow 201 shown in Fig. 7A and the like indicates the upward direction 201, similarly to Fig. 1 and the like.

### (Silicon Wafer)

As shown in Fig. 7A, the second electrode 32 and the second oxide film 33 are sequentially formed on the principal surface 75 of the second silicon substrate 31. Thereafter, the opening 42 for exposing the second electrode 32 is formed in the second oxide film 33.

### (Polyimide Coating)

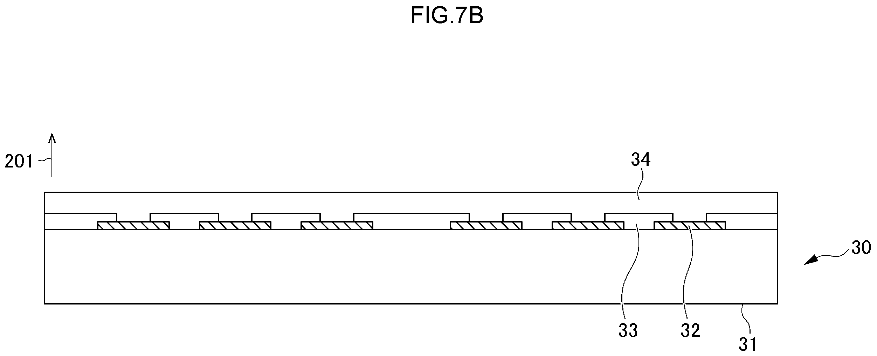

As shown in Fig. 7B, the second organic insulating film 34 is formed on the second oxide film 33 and the exposed second electrode 32. A material of the second organic insulating film 34 can be, for example, photosensitive polyimide.

### (Polyimide Opening and Sputtering)

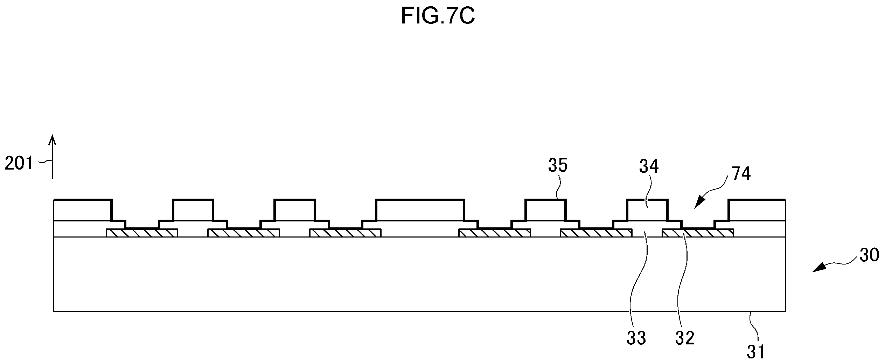

As shown in Fig. 7C, the opening 74 for exposing the second electrode 32 is formed in the second organic insulating film 34. The opening 74 can be formed by using an exposure and development step. Next, the second metal film 35 is formed over an entire surface of a portion exposed on the upward direction 201 side of the second silicon substrate 31. Formation of the second metal film 35 can be performed, for example, by sputtering. The second metal film 35 can serve as a seed electrode when a bump is formed by plating.

### (Entire Surface Plating)

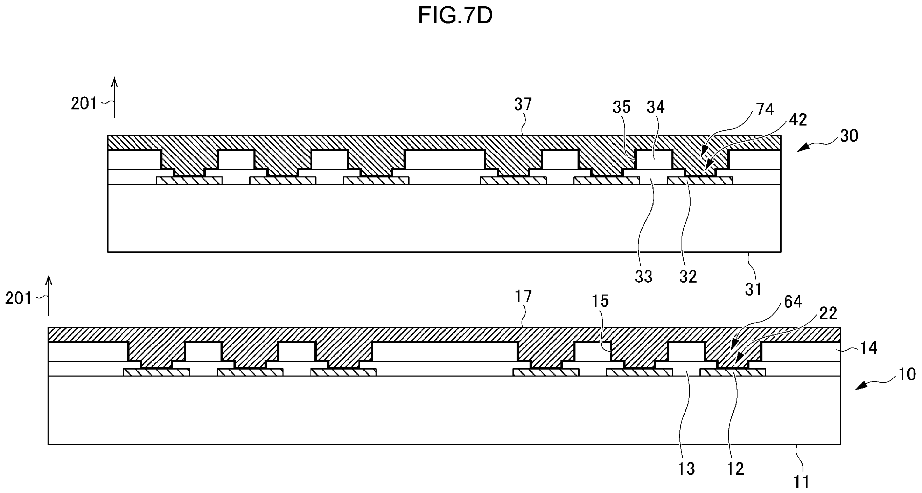

As shown in Fig. 7D, in the second semiconductor die 30, plating is performed over an entire surface on the second metal film 35. The plating is performed so that the second organic insulating film 34 is covered. The plating metal is solder. The formed plated layer is referred to as a second bump metal layer 37.

Also in the first semiconductor die 10, which has been prepared similarly to the second semiconductor die 30, plating is performed over an entire surface on the first metal film 15. The plating is performed so that the first organic insulating film 14 is covered. The plating metal is copper. The formed plated layer is referred to as a first bump metal layer 17.

### (Chemical Mechanical Polishing (CMP))

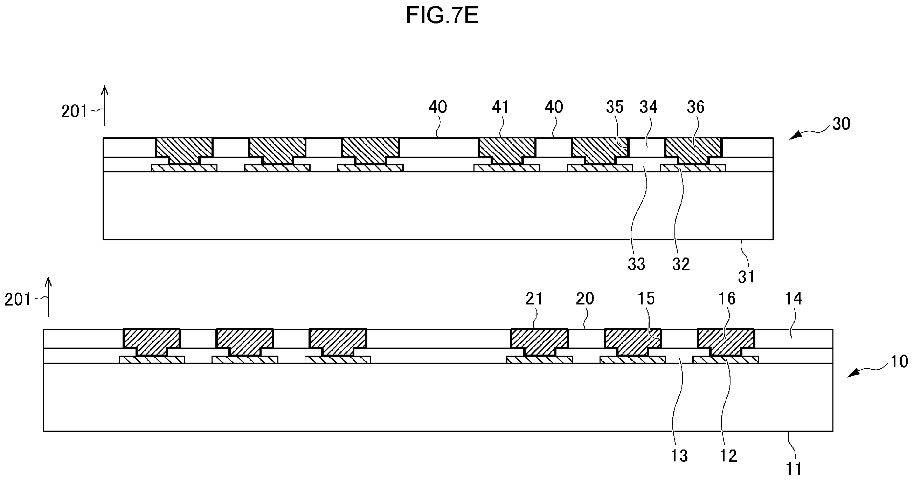

As shown in Fig. 7E, in the first semiconductor die 10, the first bump metal layer 17 is polished by CMP. In the second semiconductor die 30, the second bump metal layer 37 is polished by CMP. By the polishing, the first bump 16 and the second bump 36 are formed. In addition, by the polishing, in the first semiconductor die 10, the surface 20 of the first organic insulating film 14 and the surface 21 of the first bump 16 are made flush with each other. In the second semiconductor die 30, the surface 40 of the second organic insulating film and the surface 41 of the second bump 36 are made flush with each other.

In CMP, an end position of polishing can be determined by using a difference in polishing rate between the organic insulating film and the bump metal layer.

### (Laser Grooving (Groove Cutting) and Dicing)

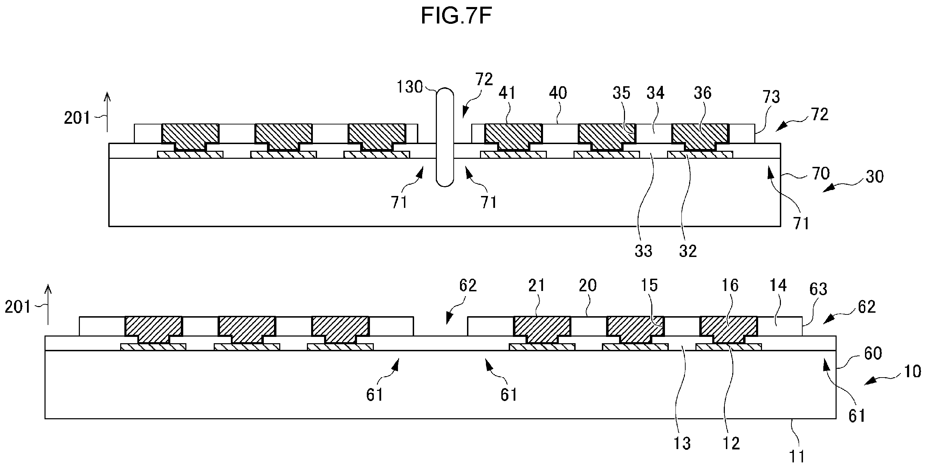

As shown in Fig. 7F, in the first semiconductor die 10, the first organic insulating film 14 located in the outer peripheral portion 61 of the first semiconductor die 10 is removed by laser grooving. As a result, the missing portion 62 of the first organic insulating film 14, where the first organic insulating film 14 is not present, is formed in the outer peripheral portion 61 of the first semiconductor die 10.

Similarly, in the second semiconductor die 30, the second organic insulating film 34 located in the outer peripheral portion 71 of the second semiconductor die 30 is removed by laser grooving. As a result, in the outer peripheral portion 61 of the second semiconductor die 30, the missing portion 72 of the second organic insulating film 34, which is a portion where the second organic insulating film 34 has been removed and the second organic insulating film 34 is not present, is formed.

Next, for the second semiconductor die 30, a chip is formed by dicing. The dicing can be performed, for example, by using a blade 130. In the above description, the missing portion of the organic insulating film is formed by laser grooving. A method for forming the missing portion of the organic insulating film is not limited to laser grooving. The missing portion of the organic insulating film can also be formed by cutting away the organic insulating film located in the outer peripheral portion of the semiconductor die during dicing.

### (Flip-Chip Connection)

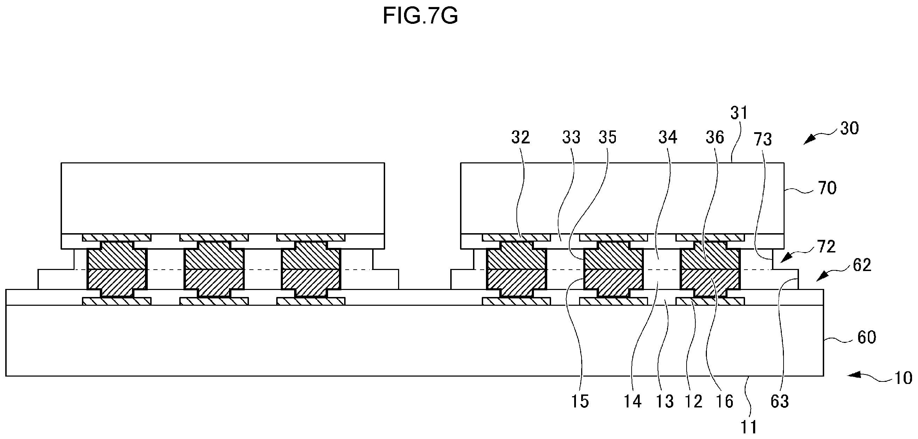

As shown in Fig. 7G, the first semiconductor die 10 and the second semiconductor die 30 are flip-chip connected.

### (Molding and Backside Grinding (Grinding Processing))

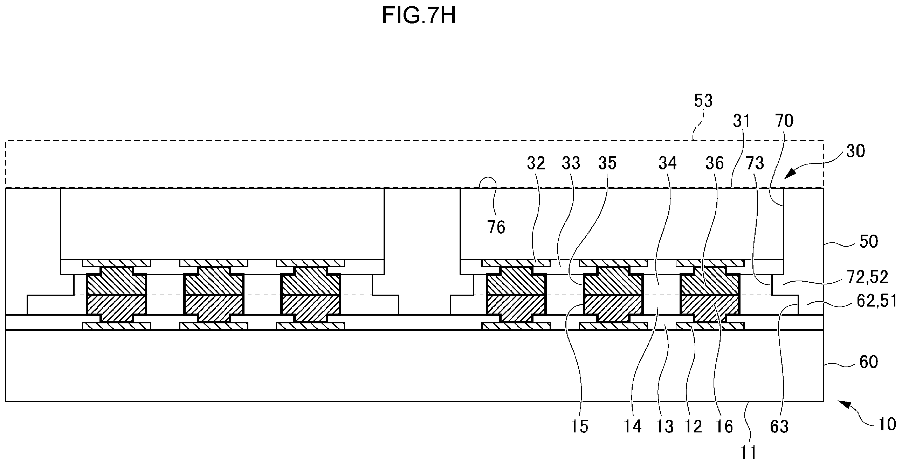

As shown in Fig. 7H, the flip-chip connected first semiconductor die 10 and second semiconductor die 30 are molded with mold resin 50. By the molding, the mold resin portion 50 including the first insulating film side surface filling portion 51 and the second insulating film side surface filling portion 52 is formed.

Subsequently, a backside portion 53 of the mold resin portion 50, located on a back surface 76 side of the second silicon substrate 31, is removed by grinding.

### (Singulation)

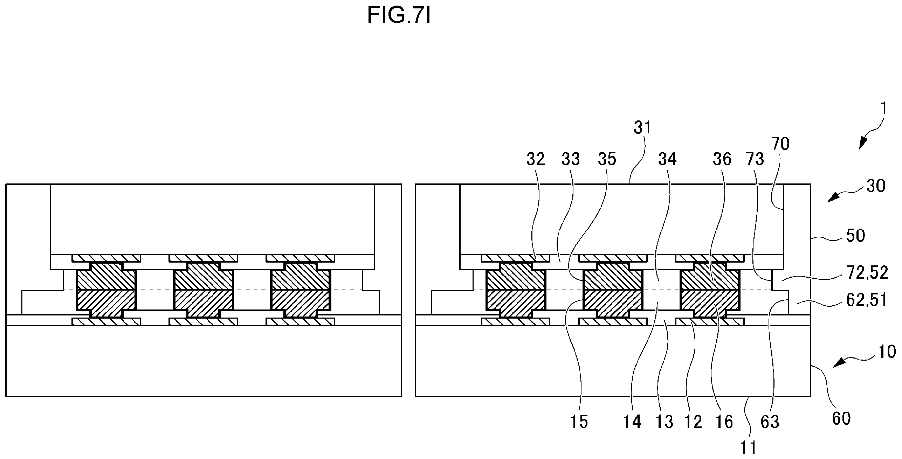

As shown in Fig. 7I, singulation is performed by, for example, dicing or the like, and a package, namely, the semiconductor device 1, is cut out. The semiconductor device 1 can be manufactured as described above.

### (Second Embodiment)

Regarding the semiconductor device 1 of the present invention, another embodiment different from the embodiment described above will be described. Hereinafter, the embodiment described above is referred to as a first embodiment, and another embodiment described below is referred to as a second embodiment. In the following description, matters different from the first embodiment will mainly be described. Matters not particularly described for the second embodiment can be similar to the first embodiment.

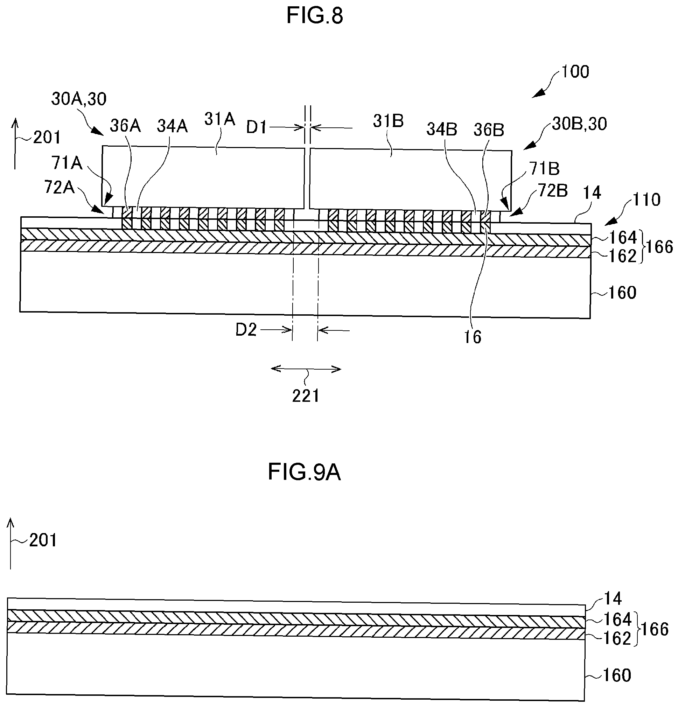

Fig. 8 is a cross-sectional view of a semiconductor device 100 according to the second embodiment of the present invention. In the semiconductor device 1 of the first embodiment, as shown in Fig. 1, one second semiconductor die 30 is flip-chip connected to the first semiconductor die 10 as another wiring substrate. In contrast, in the semiconductor device 100 of the second embodiment, as shown in Fig. 8, a plurality of second semiconductor dies 30 is flip-chip connected to another wiring substrate. Examples of the other wiring substrate include a semiconductor die including active elements such as semiconductor elements, a wiring-only substrate that does not include active elements, such as a silicon interposer, and a substrate in which a wiring layer is formed on a glass carrier. Hereinafter, the semiconductor device 100 will be described in sequence by taking, as an example, a case where the wiring substrate is a carrier wiring substrate 110.

### (First Chip and Second Chip)

First, the second semiconductor die 30 in the second embodiment will be described. In the second embodiment, the plurality of second semiconductor dies 30 is connected to the carrier wiring substrate 110. In the following description, attention is given to two of the plurality of second semiconductor dies 30. The two second semiconductor dies 30 under consideration are referred to as a first chip 30A and a second chip 30B. The first chip 30A and the second chip 30B have structures similar to the second semiconductor die 30 described in the first embodiment. In the following description and drawings, with respect to members described for the second semiconductor die 30 in the first embodiment, the members of the first chip 30A are denoted by adding A to the reference signs. Similarly, the members of the second chip 30B are denoted by adding B to the reference signs. The number of the second semiconductor dies 30 connected to the carrier wiring substrate 110 is not limited to two.

### (Carrier Wiring Substrate)

The carrier wiring substrate 110 will be described. The carrier wiring substrate 110 includes a carrier substrate 160 and a wiring layer 166 formed on the carrier substrate 160. Also in the second embodiment, similarly to the first embodiment, a direction indicated by the arrow 201 is taken as the upward direction.

### (Carrier Substrate)

The carrier substrate 160 can be formed of, for example, a glass substrate or a silicon substrate. The carrier substrate 160 is removed after the semiconductor die 30 is connected to the carrier wiring substrate 110.

### (Wiring Layer)

The wiring layer 166 includes an electrode layer 162 and an insulating layer 164. The first chip 30A and the second chip 30B connected to the carrier wiring substrate 110 are mounted on an organic substrate and the like through the wiring layer 166 after the carrier substrate 160 is removed. At that time, the wiring layer 166 functions as a redistribution layer for electrically connecting the first chip 30A or the second chip 30B and the organic substrate.

### (Insulating Layer)

The insulating layer 164 can be formed of, for example, polyimide or polybenzoxazole. Wiring not shown is formed in the insulating layer 164. The wiring formed in the insulating layer 164 is led out to two principal surfaces, namely an upper side and a lower side of the insulating layer 164.

### (Electrode Layer)

The electrode layer 162 is a layer in which electrodes on the wiring layer 166 side are formed at a time when the carrier substrate 160 is removed and the wiring layer 166 is mounted on an organic substrate and the like. The wiring layer 166 and the organic substrate and the like are connected by, for example, BGA connection. In the electrode layer 162, electrodes are formed in a form corresponding to solder balls in BGA connection, for example.

On the wiring layer 166, the first organic insulating film 14 and the first bump 16 are formed similarly to the first embodiment. The first bump 16 is disposed at a position corresponding to wiring (electrodes) led out to the upper principal surface of the insulating layer 164.

### (Connection Between Chips and Carrier Wiring Substrate)

Connection between the first chip 30A and the second chip 30B and the carrier wiring substrate 110 will be described. As shown in Fig. 8, a second bump 36A of the first chip 30A and a second bump 36B of the second chip 30B are connected to the first bumps 16 of the carrier wiring substrate 110. In addition, a second organic insulating film 34A of the first chip 30A and a second organic insulating film 34B of the second chip 30B are connected to the first organic insulating film 14 of the carrier wiring substrate 110. In this manner, the first chip 30A and the second chip 30B are flip-chip connected to the carrier wiring substrate 110 similarly to the second semiconductor die 30 of the first embodiment.

### (Chip Proximity)

Arrangement of the first chip 30A and the second chip 30B will be described. A double-headed arrow 221 shown in Fig. 8 is referred to as a first arrangement direction 221 of the first chip 30A and the second chip 30B. In the semiconductor device 100 of the second embodiment, the adjacent first chip 30A and second chip 30B are disposed close to each other in the first arrangement direction 221. A distance D1 in Fig. 8 indicates a distance D1 in the first arrangement direction 221 between a second silicon substrate 31A of the first chip 30A and a second silicon substrate 31B of the second chip 30B. A distance D2 in Fig. 8 indicates a distance D2 in the first arrangement direction 221 between the second organic insulating film 34A of the first chip 30A and the second organic insulating film 34B of the second chip 30B. The distance D1 is shorter than the distance D2. That is, a distance between silicon substrates of adjacent chips is shorter than a distance between organic insulating films of the adjacent chips. The distance D1 can be, for example, less than 50 µm, and further 10 µm or less.

As a result, in a semiconductor device in which a plurality of chips is arranged in parallel, chips can be disposed on the carrier wiring substrate 110 at an extremely high density. In addition, the plurality of chips is disposed close to each other, so that finer pitches of wiring or electrodes become possible. Therefore, a distance between connections of adjacent chips can be minimized, and high-speed transmission becomes possible.

Also in the second embodiment, as shown in Fig. 8, missing portions 72A and 72B of the second organic insulating film 34 (34A, 34B) are formed in outer peripheral portions 71A and 71B of the second semiconductor die. As a result, also in the semiconductor device 100 of the second embodiment, highly reliable flip-chip connection can be realized similarly to the semiconductor device 1 of the first embodiment. The semiconductor device 100 after flip-chip connection may also be molded with mold resin, similarly to the first embodiment. In addition, outer peripheries of the second organic insulating films 34A and 34B may be covered with mold resin.

### (Method for Manufacturing Semiconductor Device of Second Embodiment)

A method for manufacturing the semiconductor device 100 of the second embodiment will be described. In the following description, description of portions similar to the method for manufacturing the semiconductor device 1 of the first embodiment is omitted.

### (Method for Manufacturing Carrier Wiring Substrate)

With reference to Figs. 9A to 9D, a method for manufacturing the carrier wiring substrate 110 will be described. Figs. 9A to 9D are cross-sectional views of the carrier substrate 160 and the like for explaining the method for manufacturing the carrier wiring substrate 110 of the present embodiment.

First, as shown in Fig. 9A, a substrate is prepared in which the electrode layer 162, the insulating layer 164, and the first organic insulating film 14 are formed on one principal surface of the carrier substrate 160. Electrodes included in the electrode layer 162 can be formed of copper, for example. In addition, an arrangement of the electrodes can be, for example, an arrangement corresponding to BGA connection.

The insulating layer 164 can be formed mainly of an insulating material such as polyimide or polybenzoxazole. In addition, in the insulating layer 164, a through via, wiring, and the like can be formed as necessary.

The first organic insulating film 14 can be formed similarly to the first embodiment.

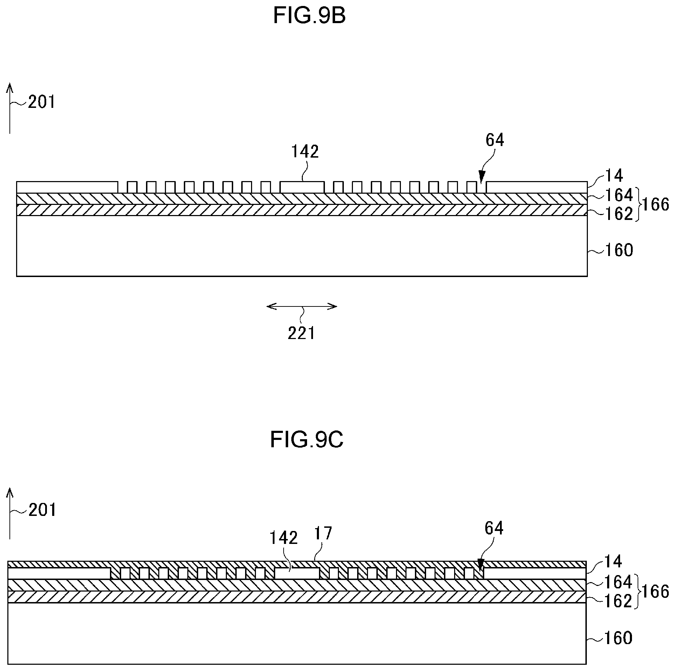

Next, as shown in Fig. 9B, the opening 64 of the first organic insulating film is formed in the first organic insulating film 14. An electrode not shown, disposed on the surface of the insulating layer 164, is exposed from the opening 64 of the first organic insulating film. The opening 64 of the first organic insulating film can be formed by using an exposure and development step. In addition, the opening 64 of the first organic insulating film is formed at a position corresponding to an electrode arrangement of chips to be subsequently connected to the carrier wiring substrate 110. In the present embodiment, at least two chips are disposed close to each other on the carrier wiring substrate 110. Therefore, an inter-chip portion 142 of the first organic insulating film, elongated in the first arrangement direction 221, may be formed at a position between a position where the first chip 30A is connected and a position where the second chip 30B is connected.

Next, as shown in Fig. 9C, entire surface plating is performed on the surface of the first organic insulating film 14 and in the opening 64 of the first organic insulating film. As a result, the first bump metal layer 17 that fills the opening 64 of the first organic insulating film and covers the first organic insulating film 14 is formed. Before the plating, for example, a seed electrode may be formed on an inner surface of the opening 64 of the first organic insulating film and on the surface of the first organic insulating film 14 by sputtering.

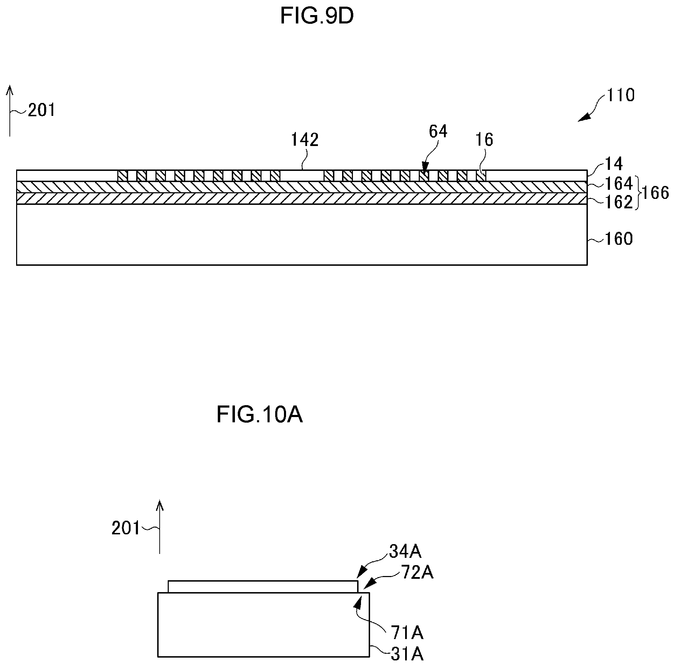

Next, as shown in Fig. 9D, the first bump metal layer 17 is polished by CMP. By the polishing, the first bump metal layer 17 on the first organic insulating film 14 is removed, and the first bump 16 is formed. The carrier wiring substrate 110 is thus prepared.

### (Method for Manufacturing Chip)

Next, with reference to Figs. 10A to 10D, a method for manufacturing a chip will be described. Figs. 10A to 10D are cross-sectional views of the second silicon substrate 31A and the like for explaining the method for manufacturing the first chip 30A. In the following description, the method for manufacturing a chip will be described by taking the first chip 30A as an example. The second chip 30B can also be manufactured similarly to the first chip 30A.

First, as shown in Fig. 10A, the second organic insulating film 34 is formed on one principal surface of the second silicon substrate 31A. At that time, similarly to the first embodiment, the missing portion 72A of the second organic insulating film is formed in the outer peripheral portion 71A of the second semiconductor die.

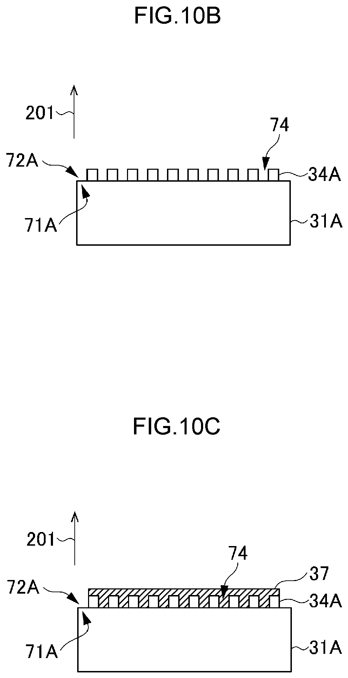

Next, as shown in Fig. 10B, the opening 74 of the second organic insulating film is formed in the second organic insulating film 34A. An electrode (not shown), disposed on the surface of the second silicon substrate 31A, is exposed from the opening 74 of the second organic insulating film. The opening 74 of the organic insulating film can be formed by using an exposure and development step. Thereafter, the organic insulating film is cured.

Next, as shown in Fig. 10C, entire surface plating is performed on the surface of the second organic insulating film 34A and in the opening 74 of the second organic insulating film. As a result, the second bump metal layer 37 that fills the opening 74 of the second organic insulating film and covers the second organic insulating film 34A is formed. Before the plating, for example, a seed electrode may be formed on an inner surface of the opening 74 of the second organic insulating film and on the surface of the second organic insulating film 34A by sputtering.

In this manner, a chip preparation step for preparing a chip includes a film formation step of forming an organic insulating film on one principal surface of a chip on which electrodes are formed, an opening step of opening the organic insulating film on the electrodes, a curing step of curing the organic insulating film, a filling step of filling metal into the opened portion, and an outer peripheral portion removal step of removing the organic insulating film in an outer peripheral portion of the chip, but the outer peripheral portion removal step may be performed at any timing between the film formation step and the opening step, between the opening step and the curing step, between the curing step and the filling step, or after the filling step, and regardless of which timing is employed, the outer peripheral portion removal step is included in the above-described chip preparation step.

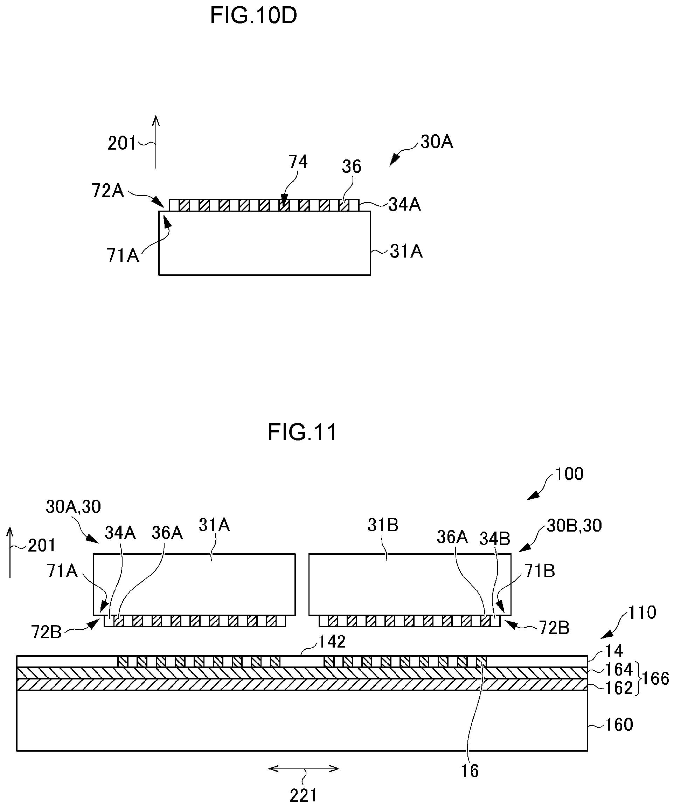

Next, as shown in Fig. 10D, the second bump metal layer 37 is polished by CMP. By the polishing, the second bump metal layer 37 on the second organic insulating film 34A is removed, and the second bump 36 is formed. The first chip 30A is thus prepared. The second chip 30B can also be prepared similarly.

Next, flip-chip connection will be described with reference to Fig. 11. Fig. 11 is a view showing a state in which the first chip 30A and the second chip 30B are flip-chip connected to the carrier wiring substrate 110. As shown in Fig. 11, the first chip 30A and the second chip 30B are connected to the carrier wiring substrate 110 at positions close to each other in the first arrangement direction 221. At the time of connection, similarly to the first embodiment, the second bump 36A and the second bump 36B are aligned with the first bump 16. In addition, the second organic insulating film 34A and the second organic insulating film 34B are brought into contact with the first organic insulating film 14. For example, the second bump 36A of the first chip 30A and the first bump 16 are aligned to bring their opposing surfaces into contact with each other, and bonding and connection are simultaneously performed by heat and load, and subsequently the second bump 36B of the second chip 30B and the first bump 16 are aligned to bring their opposing surfaces into contact with each other, and bonding and connection are simultaneously performed by heat and load, and the first chip 30A and the second chip 30B are mounted in a state in which substantially no gap is present between the first chip 30A and the second chip 30B. Here, bonding means bonding of the organic insulating films, and connection means connection of metals such as bumps. In this manner, the semiconductor device 100 of the second embodiment is manufactured.

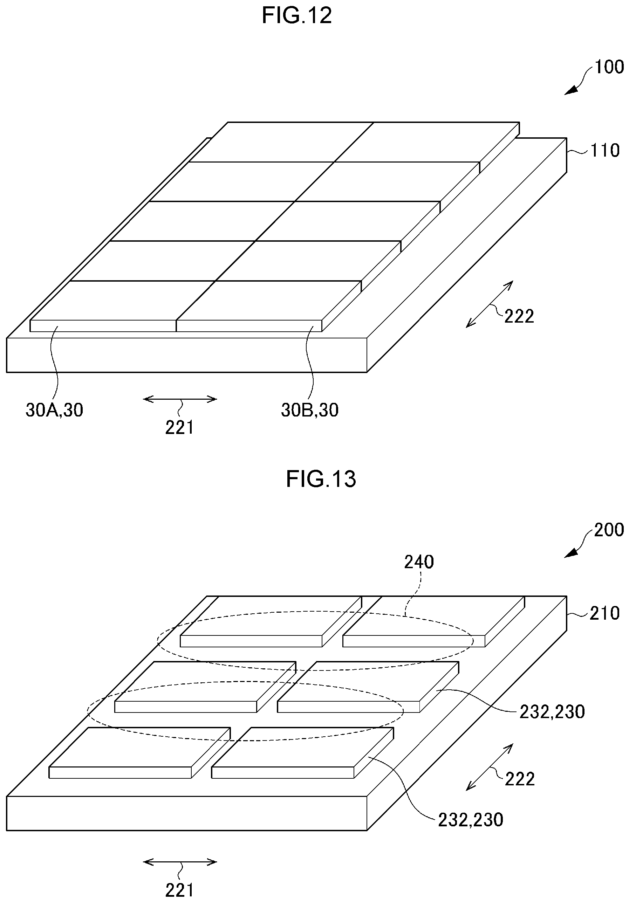

With reference to Figs. 12 and 13, an example of an overall structure of the semiconductor device 100 of the second embodiment will be described. Fig. 12 is a view showing an example of the overall structure of the semiconductor device 100 of the second embodiment. Fig. 13 is a view showing an example of the overall structure of the conventional semiconductor device 200. An arrow 222 in Figs. 12 and 13 indicates a second arrangement direction 222. The second arrangement direction 222 is a direction orthogonal to the first arrangement direction 221.

As shown in Fig. 12, in the semiconductor device 100 of the present embodiment, adjacent second semiconductor dies 30 are connected to the carrier wiring substrate 110 in a close state not only in the first arrangement direction 221 described with reference to Fig. 8 but also in the second arrangement direction 222. Therefore, the second semiconductor dies 30, that is, chips, can be arranged on the carrier wiring substrate 110 at high density.

On the other hand, in the conventional semiconductor device 200 shown in Fig. 13, it is difficult to arrange chips 230 on a substrate 210 such as a carrier wiring substrate at high density. In the conventional semiconductor device 200, when a plurality of chips 230 is connected to the substrate 210 in a matrix shape, a margin for filling underfill is required at at least one location of each chip. The at least one location refers to, for example, one side of a quadrilateral observed when the chip 230 has a rectangular parallelepiped shape and the chip 230 is viewed from a direction perpendicular to one principal surface of the substrate 210. A dashed-line enclosure 240 shown in Fig. 13 indicates a margin required for filling underfill. The margin is referred to as an underfill application region 240. A width of the underfill application region 240 shown in Fig. 13 in the second arrangement direction 222 is usually 50 µm or more. In the conventional semiconductor device 200, because the underfill application region 240 is required, it is difficult to arrange adjacent chips 230 close to each other, as shown by chips 231 and 232. Therefore, in the conventional semiconductor device 200, it is difficult to arrange chips at high density.

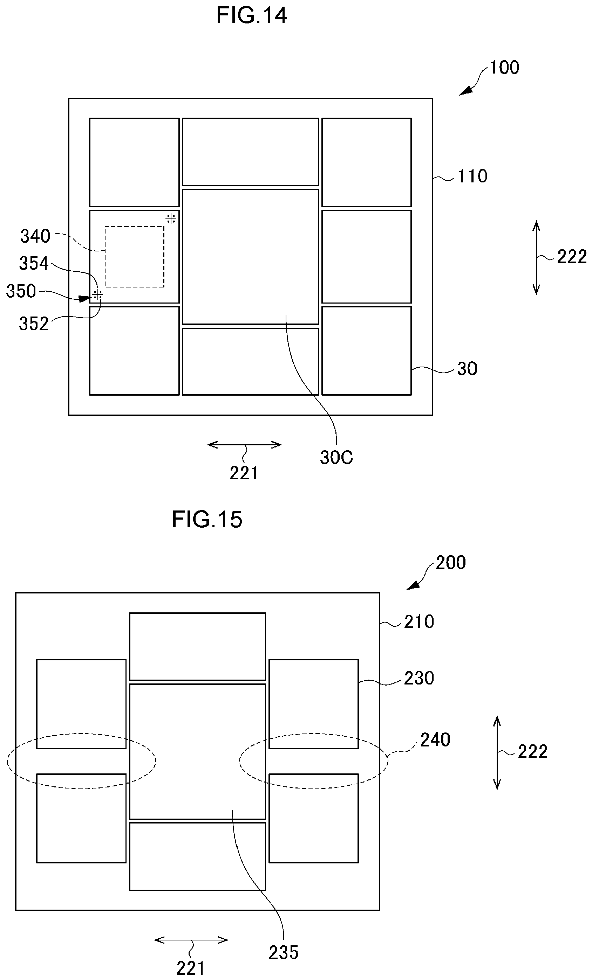

Another arrangement of chips will be described. Fig. 14 is a view of the semiconductor device 100 of the present embodiment as viewed in a direction perpendicular to one principal surface of the carrier wiring substrate 110. Fig. 15 is a view of the conventional semiconductor device 200 as viewed in a direction perpendicular to one principal surface of the wiring substrate 210. In Figs. 12 and 13 described above, sizes of chips flip-chip connected to the semiconductor device are all the same. In the examples shown in Figs. 14 and 15, a plurality of types of chips is connected to the semiconductor device. In either example shown in Figs. 14 and 15, a chip larger than the other chips is arranged in a central portion of the substrate. The chip is referred to as a center chip. Chips smaller than the center chip are arranged around the center chip.

In the conventional example shown in Fig. 15, two chips are arranged on each side of a center chip 235 in the arrangement direction 221. In the conventional semiconductor device 200, it is necessary to provide an underfill region 240 between adjacent chips. Therefore, in the conventional semiconductor device 200, the number of chips arranged on one side of the center chip 235 in the arrangement direction 221 is two.

In contrast, in the semiconductor device 100 of the present embodiment shown in Fig. 14, three chips are arranged on each side of a center chip 30C in the arrangement direction 221. In this manner, in the semiconductor device 200 of the present embodiment, it is not necessary to provide the underfill region 240, and adjacent chips can be brought close to each other, so that chips can be arranged on the substrate at high density.

### (Alignment Mark)

The alignment mark will be described. In the semiconductor device 100 of the present embodiment, high-density arrangement of chips is possible. In order to arrange chips at high density, it is preferable to perform alignment of the chips accurately. With reference to Fig. 14, an alignment mark 350 will be described. The alignment mark 350 is an alignment mark used for alignment between the second semiconductor die 30 and the carrier wiring substrate 110. The alignment mark 350 includes a first alignment mark 352 and a second alignment mark 354. The first alignment mark 352 is an alignment mark formed on the carrier wiring substrate 110. The second alignment mark 354 is an alignment mark formed on the second semiconductor die 30 (the first chip 30A and the second chip 30B).

When the second semiconductor die 30 is connected to the carrier wiring substrate 110, alignment is performed so that the first alignment mark 352 and the second alignment mark 354 have a predetermined positional relationship. In the example shown in Fig. 14, the first alignment mark 352 is four points, and the second alignment mark 354 is two orthogonal line segments. In the alignment, as shown in Fig. 14, the two line segments of the second alignment mark 354 are positioned between the four points of the first alignment mark 352. As a result, the second semiconductor die 30 and the carrier wiring substrate 110 can be accurately aligned. The first alignment mark 352 and the second alignment mark 354 shown in Fig. 14 are examples, and various changes can be made. Other examples of the alignment mark include a circle and a point that fits within the circle.

It is preferable that two or more alignment marks 350 are provided on one second semiconductor die 30. In addition, it is preferable that the alignment marks 350 are provided at diagonal positions in the second semiconductor die 30. As a result, more accurate alignment becomes possible.

It is preferable that the alignment mark 350 is formed in a region where electrodes and wiring are not formed in each of the second semiconductor die 30 and the carrier wiring substrate 110. As a result, for example, when a position of the alignment mark is checked by using infrared light, alignment can be performed without being blocked by a metal material forming electrodes or wiring.

### (Positional Relationship with Organic Insulating Film)

A positional relationship between the second organic insulating film 34 and the second alignment mark 354 will be described. In the second semiconductor die 30 of the present embodiment, the missing portion 72 of the second organic insulating film is formed in the outer peripheral portion 71 of the second semiconductor die. In the missing portion 72 of the second organic insulating film, the second organic insulating film 34 is absent. A frame 340 in Fig. 14 indicates an outer edge of the second organic insulating film 34. An outside of the frame 340 is a portion where the second organic insulating film 34 is absent, that is, a portion where the second organic insulating film 34 is not present.

It is preferable that the second alignment mark 354 is formed in the missing portion 72 of the second organic insulating film of the second silicon substrate 31. That is, it is preferable that the second alignment mark 354 is formed outside the outside of the frame 340. By forming the second alignment mark 354 in the missing portion 72 of the second organic insulating film, the second alignment mark 354 and the first alignment mark 352 can be recognized more clearly without being affected by the second organic insulating film 34. As a result, more accurate alignment becomes possible.

Embodiments of the present invention have been described above. The present invention is not limited to the above-described embodiments, and various changes, modifications, and combinations are possible.

(1) A semiconductor device including semiconductor dies each flip-chip connected to a semiconductor die to be connected or a substrate, in which each of the semiconductor dies includes a silicon substrate and an electrode formed on the silicon substrate, an organic insulating film is formed on each of the semiconductor dies, an opening that exposes the electrode is formed in the organic insulating film, an outer periphery of the organic insulating film is located inside an outer periphery of the semiconductor die, and the outer periphery of the organic insulating film is covered with mold resin.
(2) The semiconductor device according to (1), in which the opening is filled with bump metal, and a surface of the bump metal and a surface of the organic insulating film are flush with each other.
(3) The semiconductor device according to (1) to (2), in which an outer periphery of at least one semiconductor die of the two semiconductor dies is covered with the mold resin.
(4) A method for manufacturing a semiconductor device, including: a step of forming an organic insulating film on one principal surface of a semiconductor die on which an electrode is formed; a step of opening the organic insulating film on the electrode; a step of curing the organic insulating film; a step of filling metal into the opened portion; a step of removing the organic insulating film in an outer peripheral portion of the semiconductor die; a step of cutting the semiconductor die in a portion from which the organic insulating film has been removed; a step of aligning the cut semiconductor die and a semiconductor die to be connected or a substrate and simultaneously performing bonding of the organic insulating film and connection of the metal; and a step of sealing the outer peripheral portion with mold resin.
(5) The method for manufacturing a semiconductor device according to (4), includes, between the step of filling the metal and the step of removing the organic insulating film, a step of planarizing the organic insulating film formed on the one principal surface and a portion filled with the metal.
(6) A semiconductor device including a plurality of semiconductor dies each flip-chip connected to a semiconductor die to be connected or a substrate, in which each of the semiconductor dies includes a silicon substrate and an electrode formed on the silicon substrate, an organic insulating film is formed on each of the semiconductor dies, an opening that exposes the electrode is formed in the organic insulating film, an outer periphery of the organic insulating film is located inside an outer periphery of each of the semiconductor dies, and a distance between the silicon substrates of the semiconductor dies adjacent to each other is shorter than a distance between the organic insulating films.
(7) The semiconductor device according to (6), in which a distance between the silicon substrates of the semiconductor dies adjacent to each other is less than 50 µm and is shorter than a distance between the organic insulating films.
(8) The semiconductor device according to (6) or (7), in which an alignment mark for alignment with the other wiring substrate is provided in a portion where the electrode is not formed on one principal surface of each of the semiconductor dies on which the electrode is formed.
(9) A method for manufacturing a semiconductor device, including: a step of forming an organic insulating film on one principal surface of a semiconductor die on which an electrode is formed; a step of opening the organic insulating film on the electrode; a step of curing the organic insulating film; a step of filling metal into the opened portion; a step of removing the organic insulating film in an outer peripheral portion of the semiconductor die; a step of cutting the semiconductor die in a portion from which the organic insulating film has been removed; and a step of aligning a plurality of the cut semiconductor dies with a semiconductor die to be connected or a substrate in a state where a distance between silicon substrates included in the semiconductor dies adjacent to each other is shorter than a distance between the organic insulating films and simultaneously performing bonding of the organic insulating film and connection of the metal.

### Reference Signs List

- 1: Semiconductor device
- 2: Outer periphery of semiconductor device
- 10: First semiconductor die (Other wiring substrate)
- 11: First silicon substrate
- 12: First electrode
- 13: First oxide film
- 14: First organic insulating film
- 15: First metal film
- 16: First bump
- 17: First bump metal layer
- 30: Second semiconductor die
- 30A: First chip
- 30B: Second chip
- 31: Second silicon substrate
- 32: Second electrode
- 33: Second oxide film
- 34: Second organic insulating film
- 35: Second metal film
- 36: Second bump
- 37: Second bump metal layer
- 42: Opening
- 50: Mold resin portion
- 51: First insulating film side surface filling portion of mold resin portion
- 52: Second insulating film side surface filling portion of mold resin portion
- 60: Outer periphery of first semiconductor die
- 61: Outer peripheral portion of first semiconductor die
- 62: Missing portion of first organic insulating film
- 63: Outer periphery of first organic insulating film
- 64: Opening of first organic insulating film
- 70: Outer periphery of second semiconductor die
- 71: Outer peripheral portion of second semiconductor die
- 72: Missing portion of second organic insulating film
- 73: Outer periphery of second organic insulating film
- 74: Opening of second organic insulating film
- 75: Principal surface of second silicon substrate
- 81: Underfill
- 82: Device opposing portion
- 83: Wetting rise portion
- 84: Wetting spread portion
- 90: Package substrate
- 100: Semiconductor device
- 110: Carrier wiring substrate
- 142: Inter-chip portion
- 162: Electrode layer
- 164: Insulating layer
- 166: Wiring layer
- 205: Corner portion of second semiconductor die on first semiconductor die side
- 206: Corner portion of first semiconductor die on second semiconductor die side
- 221: First arrangement direction
- 222: Second arrangement direction

## Claims

1. A semiconductor device comprising a semiconductor die flip-chip connected to a semiconductor die to be connected or a substrate,
wherein the semiconductor die includes a silicon substrate and an electrode formed on the silicon substrate,
an organic insulating film is formed on the semiconductor die,
an opening that exposes the electrode is formed in the organic insulating film,
an outer periphery of the organic insulating film is located inside an outer periphery of the semiconductor die, and the outer periphery of the organic insulating film is covered with mold resin.

2. The semiconductor device according to claim 1,
wherein the opening is filled with bump metal, and
a surface of the bump metal and a surface of the organic insulating film are flush with each other.

3. The semiconductor device according to claim 1, wherein an outer periphery of the semiconductor die is covered with the mold resin.

4. A method for manufacturing a semiconductor device, comprising: forming an organic insulating film on one principal surface of a semiconductor die on which an electrode is formed;
opening the organic insulating film on the electrode;
curing the organic insulating film;
filling metal into the opened portion;
removing the organic insulating film in an outer peripheral portion of the semiconductor die;
cutting the semiconductor die in a portion from which the organic insulating film has been removed;
aligning the cut semiconductor die and a semiconductor die to be connected or a substrate and simultaneously performing bonding of the organic insulating film and connection of the metal; and
sealing the outer peripheral portion with mold resin.

5. The method for manufacturing a semiconductor device according to claim 4, further comprising, between the step of filling the metal and the step of removing the organic insulating film, a step of planarizing the organic insulating film formed on the one principal surface and a portion filled with the metal.

6. A semiconductor device comprising a plurality of semiconductor dies each flip-chip connected to a semiconductor die to be connected or a substrate,
wherein each of the semiconductor dies includes a silicon substrate and an electrode formed on the silicon substrate,
an organic insulating film is formed on each of the semiconductor dies,
an opening that exposes the electrode is formed in the organic insulating film,
an outer periphery of the organic insulating film is located inside an outer periphery of each of the semiconductor dies, and a distance between the silicon substrates of the semiconductor dies adjacent to each other is shorter than a distance between the organic insulating films.

7. The semiconductor device according to claim 6, wherein a distance between the silicon substrates of the semiconductor dies adjacent to each other is less than 50 µm and is shorter than a distance between the organic insulating films.

8. The semiconductor device according to claim 6, wherein an alignment mark for alignment with the other wiring substrate is provided in a portion where the electrode is not formed on one principal surface of each of the semiconductor dies on which the electrode is formed.

9. A method for manufacturing a semiconductor device, comprising: forming an organic insulating film on one principal surface of a semiconductor die on which an electrode is formed;
opening the organic insulating film on the electrode;
curing the organic insulating film;
filling metal into the opened portion;
removing the organic insulating film in an outer peripheral portion of the semiconductor die;
cutting the semiconductor die in a portion from which the organic insulating film has been removed; and aligning a plurality of the cut semiconductor dies with a semiconductor die to be connected or a substrate in a state where a distance between silicon substrates included in the semiconductor dies adjacent to each other is shorter than a distance between the organic insulating films and simultaneously performing bonding of the organic insulating film and connection of the metal.
